# EUROPÄISCHE PATENTSCHRIFT

(11) **EP 2 114 583 B1**
(45) Veröffentlichungstag und Bekanntmachung des Hinweises auf die Patenterteilung: **22.10.2014**
(21) Anmeldenummer: 08700868.6
(22) Anmeldetag: 18.01.2008
(51) Int. Cl.: B08B 7/00, C30B 29/30, C30B 33/00, C30B 33/02, C30B 33/04

(54) **OPTISCHE REINIGUNG VON KRISTALLEN**
OPTICAL CLEANING OF CRYSTALS
NETTOYAGE OPTIQUE DE CRISTAUX

(30) Priorität: 30.01.2007 DE 102007004400
(43) Veröffentlichungstag der Anmeldung: 11.11.2009
(73) Patentinhaber: Deutsche Telekom AG, 53113 Bonn (DE)
(72) Erfinder: BUSE, Karsten, 53115 Bonn (DE); FALK, Matthias, Palo Alto, CA, 94306 (US); HAERTLE, Daniel, 53111 Bonn (DE); KÖSTERS, Michael, 53113 Bonn (DE)
(74) Vertreter: Braun-Dullaeus Pannen Patent- und Rechtsanwälte
(86) Internationale Anmeldenummer: PCT/DE2008/000079
(87) Internationale Veröffentlichungsnummer: WO 2008/092421

(56) Entgegenhaltungen:
- EP-A- 1 566 471
- WO-A-2005/068690
- BUSE, K.; BREER, S.; PEITHMANN, K.; KAPPHAN, S.; GAO, M.; KRÄTZIG, E.: "Origin of thermal fixing in photorefractive lithium niobate crystals" PHYSICAL REVIEW B, Bd. 56, Nr. 3, 15. Juli 1997 (1997-07-15), Seiten 1225-1235, XP002510662
- HOUSEI AKAZAWA, MASARU SHIMADA: "Electro-optic properties of c-axis oriented LiNbO3 films grown on Si(1 0 0) substrate" MATERIALS SCIENCE AND ENGINEERING B: SOLID-STATE MATERIALS FOR ADVANCED TECHNOLOGY, Bd. 120, Nr. 1-3, 2005, Seiten 50-54, XP002510663
- VOLK, T.; WÖHLECKE, M.: "Thermal Fixation of the Photorefractive Holograms Recorded in Lithium Niobate and Related Crystals" CRITICAL REVIEWS IN SOLID STATE AND MATERIALS SCIENCES,, Nr. 30, 2005, Seiten 125-151, XP002510664
- MÜLLER, M.; SOERGEL, E.; BUSE,K.: "Influence of ultraviolet illumination on the poling charactersitics of lithium niobate crystals" APPLIED PHYSICS LETTERS, Bd. 83, Nr. 9, 1. September 2003 (2003-09-01), Seiten 1824-1826, XP002510665
- FALK,M.;BUSE,K.: "Thermo-electric method for nearly complete oxidatization of highly iron-doped lithium niobate crystals" APPLIED PHYSICS B: LASERS AND OPTICS, Nr. 81, 2005, Seiten 853-855, XP019337552
- BUSE,K.;NEE,I.;MÜLLER,M.:KRÄTZIG,E.: "Development of thermally fixed holograms in photorefractive lithium-niobate crystals without light" OPTICAL MATERIALS, Nr. 18, 2001, Seiten 17-18, XP004321030
- AMODEI J J ET AL: "HOLOGRAPHIC PATTERN FIXING IN ELECTRO-OPTIC CRYSTALS", APPLIED PHYSICS LETTERS, AMERICAN INSTITUTE OF PHYSICS, US, vol. 18, no. 12, 15 June 1971 (1971-06-15) , pages 540-542, XP002013054, ISSN: 0003-6951, DOI: 10.1063/1.1653530

## Beschreibung

Die Erfindung betrifft ein Verfahren zur Reinigung und damit zur Vorbereitung von Kristallen, insbesondere von Lithiumniobat- oder Lithiumtantalat-Kristallen, für den Einsatz in optischen Bauteilen, insbesondere in nichtlinear-optischen und elektrooptischen Komponenten, wobei in den Kristallen Fremdatome, oder Kristalldefekte vorhanden sind, die eine spezifische Absorption von eingestrahltem Licht bewirken.

Kristalle wie Lithiumniobat oder Lithiumtantalat werden in Bauteilen für die Laseroptik, beispielsweise in Frequenzverdopplern oder in Frequenzmischern, eingesetzt. Allerdings besteht generell das Problem, dass bei intensiver Bestrahlung mit Laserlicht der durch den Kristall hindurch gehende Lichtstrahl gestört wird und damit seine Qualität verliert. Die Effizienz der Frequenzkonversion sinkt. Der Grund für den Verlust der Strahlqualität liegt darin, dass das Laserlicht Ladungsträger anregt, die dann umverteilt und an anderen Orten eingefangen werden. Dadurch werden Raumladungsfelder aufgebaut, die lokale Modulationen des Brechungsindex hervorrufen, an denen der Lichtstrahl auffächert. Zusätzlich kann der Ladungsträgertransfer eine Änderung der Absorption bewirken, wenn die Fänger der Ladungen einen anderen Photonenabsorptionswirkungsquerschnitt aufweisen. Aufgrund der Kramers-Kronig-Relationen für den komplexen Brechungsindex wird auch durch diese Absorptionsänderungen der Brechungsindex beeinflusst. Die inhomogenen Änderungen der Brechungsindizes sowie die lichtinduzierten Absorptionsänderungen werden als "optischer Schaden" bezeichnet.

Wenn nachfolgend von Elektronen gesprochen wird, seien damit ganz allgemein elektronische Ladungen gemeint. Das kann Elektronen- als auch Löchertransport umfassen.

Die Ladungsumverteilung wird im Wesentlichen von Verunreinigungen hervorgerufen, die innerhalb des Kristalls in mehreren Valenzzuständen vorkommen und die daher sowohl Elektronenspender als auch Elektronenfänger sind. In mehreren Valenzzuständen vorkommende intrinsische Kristalldefekte können diesen Prozess fördern oder auch selbständig ermöglichen. In Lithiumniobat gibt es beispielsweise die sogenannten "Antisite-Defekte", bei denen Nb^{5+/4+} auf einem Li-Platz sitzt. Zudem können die Ladungen in Zentren eingefangen werden, wo sie zu einer Absorptionserhöhung führen. All diese Effekte werden auch dem optischen Schaden zugerechnet.

Die Ursache des optischen Schadens liegt somit ganz generell darin, dass in den Kristallen Defekte vorhanden sind, bei denen Elektronen durch Licht angeregt werden können. Das bedeutet andererseits, dass der optische Schaden umso kleiner ist, je reiner der Kristall ist und je weniger Möglichkeiten zur Anregung von Ladungen er bietet.

Nun ist bekannt, schon beim Züchten der Kristalle die unerwünschten Verunreinigungen so gut es geht zu vermeiden. Es hat sich allerdings als sehr schwierig erwiesen, Kristalle mit einer Dotierung von weniger als 10 ppm an unerwünschten Ionen zu züchten. Es ist auch bekannt, den Kristall nachträglich von anregbaren Elektronen durch thermische oder thermo-elektrische Oxidation zu reinigen, indem die Elektronen spendenden Ionen oxidiert, also die Fe²⁺-Ionen in den Fe³⁺-Zustand überführt werden. Die freiwerdenden, überschüssigen Elektronen werden ladungsmäßig durch den Ein- oder Ausbau von Ionen kompensiert. Diese Verfahren sind als Temperbehandlung bekannt, wobei deren reinigende Wirkung durch Erwärmung des Kristalls auf hohe Temperaturen ermöglicht wird. An den Kristall angelegte externe elektrische Spannungen können den Vorgang unterstützen. Dabei dient das Konzentrationsverhältnis der gefüllten zu den leeren Störstellen als Maß für die Oxidation. Bei kleinem Konzentrationsverhältnis können nur entsprechend wenige Ladungen transportiert werden da die Elektronenspender fehlen. Entsprechend wird auch kein Raumladungsfeld aufgebaut Zudem können weniger Elektronen in Zentren transportiert werden, die zu stärkerer Absorption führen. Der optische Schaden ist also gemindert. Oberhalb einer "Schwellintensität" tritt der optische Schaden jedoch eventuell wieder auf, weil z. B. durch Mehrphotonenanregungen neue Anregungsmöglichkeiten geschaffen werden und andere Zentren am Ladungstransport teilnehmen.

Zur Verminderung des optischen Schadens können die Kristalle auch beispielsweise mit Magnesium dotiert werden, wobei das Dotieren jedoch andere Eigenschaften verschlechtert. So wird es beispielsweise wesentlich schwieriger, "periodisch gepolte" Kristalle zu erzeugen, bei denen die Spontanpolarisierung periodisch invertiert ist. Dieses periodische Polen ist jedoch Voraussetzung für zahlreiche nichtlinear-optische Anwendungen, wie für Frequenzkonversion mit Hilfe der "Quasi-Phasenanpassung".

Auch wenn die bekannten Verfahren einen deutlichen Reinigungseffekt haben, so reicht die Reinheit der behandelten Kristalle für Anwendungen mit Laserstrahlen hoher Intensitäten häufig noch nicht aus. Aus diesem Grund ist es bislang auch kaum möglich, beispielsweise optisch-nichtlineare oder elektro-optische Bauteile, wie Frequenzverdoppler, Frequenzmischer, optisch parametrische Oszillatoren (OPOs) oder elektro-optische Modulatoren im Zusammenhang mit Laserstrahlen hoher Intensität einzusetzen. Der optische Schaden, dem sich diese Laserstrahlen in den Bauteilen ausgesetzt sehen, beeinträchtigt deren Funktionalität bislang in unakzeptablem Maße oder die Herstellung der Komponenten ist durch die oben erwähnte Kodotierung mit Magnesium oder anderen Elementen deutlich erschwert und verteuert.

Aufgabe der Erfindung ist es nunmehr, ein Verfahren zu schaffen, das sich einfach und kostengünstig umsetzen lässt und mit dem sich die Kristalle, insbesondere Lithiumniobat und Lithiumtantalat, in bislang nicht erreichtem Maß reinigen lassen, so dass die Absorption auch intensiver Strahlung im Kristall auf ein Minimum reduziert wird.

Diese Aufgabe wird durch das Verfahren mit den kennzeichnenden Merkmalen des Anspruchs 1 gelöst. Vorteilhafte Ausgestaltungen der Erfindung sind in den Unteransprüchen genannt.

Der wesentliche Grundgedanke der Erfindung liegt darin, einen Kristall mit einem als Reinigungsstrahl wirkenden Lichtstrahl innerhalb eines Nutzbereichs für den späteren Durchtritt von Lichtstrahlen gewissermaßen zu "desensibilisieren". Dabei wird durch Verfahrensschritte sichergestellt, dass der gereinigte Nutzbereich als solcher für den späteren Einsatz verhalten bleibt und sich der reinigende Prozess nicht wieder ohne weiteres umkehren kann. Erfindungsgemäß wird im Rahmen dieses Reinigungsverfahrens der Kristall zunächst auf eine Temperatur erwärmt, die so zu bemessen ist, dass Ionen in ausreichendem Maße beweglich werden und eine entsprechende ionische Leitfähigkeit zu beobachten ist. Dabei sind für die ionische Leitfähigkeit insbesondere in Lithiumniobat- und Lithiumtantalat-Kristallen neben den Li⁺-Ionen auch die immer vorhandenen H⁺-Ionen verantwortlich. Um es zu betonen: Hier ist die Umverteilung ganzer Ionen gemeint und nicht - wie oben als Ursache des optischen Schadens beschrieben - die Umverteilung von Ladungsträgern (Elektronen im Leitungsband oder Löcher im Valenzband), die aus Ionen und Kristallfehlstellen stammen.

In diesem Zustand der hohen Ionenbeweglichkeit wird der Kristall mit einem Lichtstrahl einer Frequenz im sichtbaren Bereich oder nahe des sichtbaren Bereichs beleuchtet. Dieser Reinigungsstrahl bewirkt, dass zunächst aus Ionen oder Kristallfehlstellen Ladungsträger angeregt und umverteilt werden. Aufgrund der erhöhten Temperatur findet zeitgleich ein weiterer Prozess statt: Die Ionen driften in dem erzeugten elektrischen Feld und kompensieren die umverteilten Ladungen. Das Raumladungsfeld wird auf diese Art und Weise klein gehalten. Das Licht verteilt weitere Ladungsträger aus den Ionen und Kristallfehlstellen um, die dann ebenfalls von driftenden Ionen kompensiert werden. Damit tritt eine Reinigung des Kristalls ein. Mit dieser Reinigung würde ein stationärer Zustand erst dann erreicht, wenn im beleuchteten Bereich keine mit Licht anregbaren Ladungen mehr vorhanden sind, sofern genug Ionen zur Kompensation aller mit Licht umverteilten Elektronen oder Löcher zur Verfügung stehen.

Insbesondere ist es vorteilhaft, für diese Reinigung einen Strahl mit Intensitätsprofil zu verwenden, so dass im Kristall hellere und dunklere Bereiche vorhanden sind. Erfindungsgemäß ist der Querschnitt des Reinigungsstrahls von "makroskopischer" Abmessung, die im Mikrometer- bis Millimeterbereich liegt. Da nur in den helleren Bereichen das Licht die Ladungsumverteilung antreiben kann, sammeln sich die Elektronen in den dunkleren Bereichen an und werden dort von Ionen kompensiert.Der elektronische Ladungstransport kann entweder wandernde Elektronen oder wandernde Löcher oder beides beinhalten. Mit einem inhomogenen Reinigungsstrahl werden daher wie mit einem Besen Ladungen nach der optischen Anregung aus den beleuchteten Bereichen in die Dunkelzone zugekehrt", wo sich elektronische Ladungen mit denen der Ionen kompensieren.

Durch die Bewegung und die Kompensation entsteht im Kristall eine gereinigte und damit für spätere Zwecke nutzbare Zone. Diese Zone wird durch das Abkühlen des Kristalls beispielsweise auf die zukünftige Betriebstemperatur, insbesondere auf Raumtemperatur, dadurch "sauber" gehalten, dass der Zustand gewissermaßen eingefroren wird: Ionen wie z. B. H⁺ und Li⁺ sind in Lithiumniobat- und Lithiumtantalat-Kristallen bei Raumtemperatur nahezu unbeweglich. Daher sind auch die dort haftenden umverteilten Ladungen fixiert, und der Reinigungsprozess ist stabil. Auf diese Art können die Kristalle im Rahmen der nutzbaren Zone robust gegenüber weiterer Beleuchtung gemacht werden, so dass sie insbesondere für nichtlinear-optische und elektro-optische Bauteile auch bei hohen Lichtleistungen einsetzbar sind. Dabei werden in einer besonders vorteilhaften Ausführungsform die nutzbaren Zonen aus dem gereinigten Kristall herauspräpariert, was beispielsweise dadurch geschehen kann, dass der Kristall von den ungereinigten Bereichen, insbesondere durch mechanisches Abschneiden, befreit wird.

Die für den Ladungstransport erforderlichen beweglichen Ionen, insbesondere H⁺-Ionen oder Li⁺-Ionen bei Lithiumniobat und Lithiumtantalat, sind im Kristall vorhanden. Ihre Beweglichkeit wächst gemäß dem Arrhenius-Gesetz exponentiell mit steigender Temperatur. Als für das vorgestellte Verfahren geeigneter Temperaturbereich hat sich der Bereich zwischen etwa 150 und 220 °C herausgestellt, die ionische Leitfähigkeit σᵢₒₙ hat dort einen Wert, bei der die "ionische Maxwell-Zeit" τᵢₒₙ = εε₀/σᵢₒₙ im Bereich zwischen Sekunden und Minuten liegt. Dabei bezeichnen ε die Dielektrizitätskonstante des Materials und ε₀ die des Vakuums. Innerhalb dieser "ionischen Maxwell-Zeit" fallen im Kristall Raumladungsfelder aufgrund der ionischen Leitfähigkeit um den Faktor 1/e ab. Um eine ausreichende Menge geeigneter Ionen für die Kompensation zur Verfügung zu haben, kann es vorteilhaft sein, den Kristall im Vorfeld der erfindungsgemäßen Reinigung durch thermische Behandlungen bei höheren Temperaturen, insbesondere in feuchter Atmosphäre, gezielt mit Ionen zu füllen.

Auch die Elektronen können thermisch aus Störstellen angeregt werden, wobei auch hier das Arrhenius-Gesetz entsprechend gilt. Allerdings ist die Aktivierungsenergie im Fall der Elektronen und damit die Temperaturabhängigkeit größer. Die Elektronen dominieren daher erst bei höheren Temperaturen die thermische Leitfähigkeit, während bis ca. 200 °C die ionische Leitfähigkeit dominiert. Die elektronische Leitfähigkeit lässt sich jedoch durch lichtinduzierte Anregung und Umverteilung, wie oben beschrieben, über einen großen Bereich einstellen. Günstig ist dabei eine Lichtintensität des Reinigungslichts, die dazu führt, dass die "elektronische Maxwell-Zeit" τ_{electron} = εε₀/σ_{electron} in etwa gleich der ionischen Maxwell-Zeit τᵢₒₙ ist, wobei σ_{electron} die durch das Reinigungslicht erzeugte elektronische Leitfähigkeit bezeichnet

In Lithiumniobat- und Lithiumtantalat-Kristallen ist der "volumenphotovoltaische Effekt" bei der Umverteilung der angeregten Ladungsträger dominant, der daher rührt, dass diese Kristalle azentrisch sind und damit eine Vorzugsrichtung haben. Es kann vorteilhaft sein, den Reinigungsstrahl entlang der Richtung des volumenphotovoltaischen Effektes zu führen, also quasi "mit dem Wind zu fegen".

Um den Transport der Elektronen zu fördern, kann es auch sinnvoll sein, als Ladungsträgerantrieb zusätzlich ein äußeres elektrisches Feld anzulegen, welches über die Coulomb-Kraft eine Drift der Elektronen verursacht. Wenn von Vornherein bekannt ist, bei welcher Wellenlänge der Kristall später eingesetzt werden soll, ist es vorteilhaft, wenn der reinigende Laserstrahl eine Wellenlänge aufweist, die zumindest nahe zu der des später einzusetzenden Lichts oder der des später durch den Kristall mittels eines nichtlinear-optischen Effekts erzeugten Lichts ist. Durch diese Maßnahme ist eine besonders effektive Reinigung bezüglich dieser Wellenlänge gewährleistet.

Bei der hier vorgestellten Methode kann es vorteilhaft sein, den Lichtstrahl mehrfach über dem Kristall räumlich zu verfahren, um dabei jeweils weitere Elektronen zu entfernen. Das ist insofern vorteilhaft, als lokal die Änderung der Ladungsträgerdichte durch die Kontinuitätsgleichung bestimmt wird: div j + dp/dt = 0, wobei j den Vektor der Stromdichte, p die Dichte an umverteilbaren Elektronen und t die Zeit bezeichnen. Um Elektronen zu entfernen, also für dρ/dt ≠ 0, ist es nötig, dass die Stromdichte j vom Ort abhängt, div j also nicht verschwindet. Die Divergenz der Stromdichte ist aber bei einem beispielsweise gaußförmigen Muster an den Flanken groß. Es ist daher vorteilhaft, den Strahl und damit die Position der Flanken, zu verschieben, um damit jeweils eine gewisse Menge an Elektronen über größere Bereiche aus den Störstellen zu entfernen. Dieser Prozess wird vorteilhafterweise mehrfach wiederholt.

Auf diese Art wird der beleuchtete Bereich resistent gegen den "optischen Schaden", da mit der oben beschriebenen optischen Reinigung gezielt alle mit Licht der gewählten Wellenlänge anregbaren Ladungen abtransportiert und am Rand durch die Ionen gefangen werden. Daher können sich keine Raumladungsfelder und somit auch keine störenden Brechungsindex- und Absorptionsänderungen mehr aufbauen. Die Stärke der Resistenz gegen den "optischen Schaden" hängt unter anderem von der bei der optischen Reinigung eingesetzten Beleuchtungsdosis ab. Deshalb kann es vorteilhaft sein, den Strahl durch Spiegel geführt wiederholt durch den Kristall gehen zu lassen, oder den Kristall in einen Resonator zu setzen.

Der Reinigungseffekt bleibt erhalten, auch wenn die Kristalle abgekühlt werden; die Erwärmung ist nur für die Dauer des Reinigungsprozesses erforderlich.

Das erfindungsgemäße Verfahren ist dem "thermischen Fixieren" in Lithiumniobat- und Lithiumtantalat-Kristallen ähnlich, bei dem Elektronen auch mit Licht umverteilt und die elektronischen Ladungsmuster durch ionische Ladungsmuster kompensiert werden. Das thermische Fixieren ist bekannt aus BUSE; K.; BREER, S.; PEITHMANN, K.; KAPPHAN, S.; GAO, M.; KRÄTZIG, E.: "Origin of thermal fixing in photorefractive lithium niobate crystals" PHYSICAL REVIEW B, Bd. 56, Nr. 3,15. Juli 1997 (1997-07-15), Seiten 1225-1235 und zeigt den Oberbegriff des Anspruchs 1. Im Unterschied zu der Erfindung werden jedoch beim thermischen Fixieren Kristalle eingesetzt, die zur Steigerung des photorefraktiven Effekts mit Übergangsmetallionen dotiert sind. Erfindungsgemäß werden hingegen Kristalle verwendet, in die bewusst keine Ionen eingebracht werden, aus denen Licht Ladungsträger anregen kann. Das thermische Fixieren wird zur Speicherung von Hologrammen eingesetzt, wobei die Beleuchtung mit Interferenzmustern und nicht mit einzelnen Lichtstreifen oder sogar homogener Beleuchtung erfolgt. Ein wesentlicher Unterschied ist, dass die hellen Bereiche beim "thermischen Fixieren" in der Größenordnung der Lichtwellenlänge (500 nm) liegen. Bei der Erfindung wird hingegen mit einem Lichtstrahl "makroskopischer" Dimension gearbeitet, dessen Breite die Größenordnung einiger Millimeter erreichen kann. Auch wird beim thermischen Fixieren das Lichtmuster räumlich konstant gehalten, da es ja um die Speicherung des Lichtmusters in Form von Raumladungen geht. Bei dem hier vorgestellten Reinigungsverfahren kann es dagegen vorteilhaft sein, das Lichtmuster wie oben ausgeführt durch den Kristall zu bewegen.

Das erfindungsgemäße Verfahren wird nachfolgend anhand der Figuren 1 bis 3 erläutert. Die Figuren zeigen:
- **Figur 1**: ein Intensitätsprofil und drei Konzentrationsprofile,
- **Figur 2**: Konzentrationsprofile in Abhängigkeit der Behandlungsdauer und
- **Figur 3**: Konzentrationsprofile bei bewegtem Strahl mit Gauß-Profil.

Ein Lithiumniobat- oder Lithiumtantalat-Kristall, bei dem die Normale der Strahleintrittsfläche parallel zur x-Achse des Kristalls liegt, wird bei erhöhter Temperatur einem Lichtstreifen mit gaußförmiger Intensitätsverteilung entlang der z-Achse des Kristalls ausgesetzt. Die Profile werden daher nachfolgend in z-Richtung aufgetragen.

Unter optimalen Bedingungen wird die temperaturabhängige Entwicklung eines Profils einer normierten Anzahl kompensierter Ladungen N(z/z₀)/N₀ nur von der Länge der normierten Beleuchtungszeit τ = t / t₀ kontrolliert, wobei t₀ als charakteristische Zeit gegeben wird durch t₀ = z₀ ℏω / (lₚᵥ σ l₀), wobei lₚᵥ der volumenphotovoltaische Längenparameter der mittleren Bewegung des Elektrons pro absorbiertem Photon ist. σ ist der Absorptionswirkungsquerschnitt, ℏω die Energie eines Lichtquants und l₀ die Lichtintensität. Der Parameter lₚᵥ korrespondiert mit einer Darstellung der volumenphotovoltaischen Stromdichte jₚᵥ = e α l₀ lpᵥ / (ℏω), wobei e die Elementarladung und α = N σ der Lichtabsorptionskoeffizient sind. Die Parameter lₚᵥ und σ sind aus Experimenten bekannt. Typischerweise ist lₚᵥ = (0,5 - 1) × 10⁻⁸ cm und σ etwa 5 × 10⁻¹⁶cm² bei λ = 500 nm. Für eine Spitzenintensität l₀ = 1 W/cm² und einer Gaußweite z₀ = 1 mm, wird t₀ auf ungefähr 5 h geschätzt.

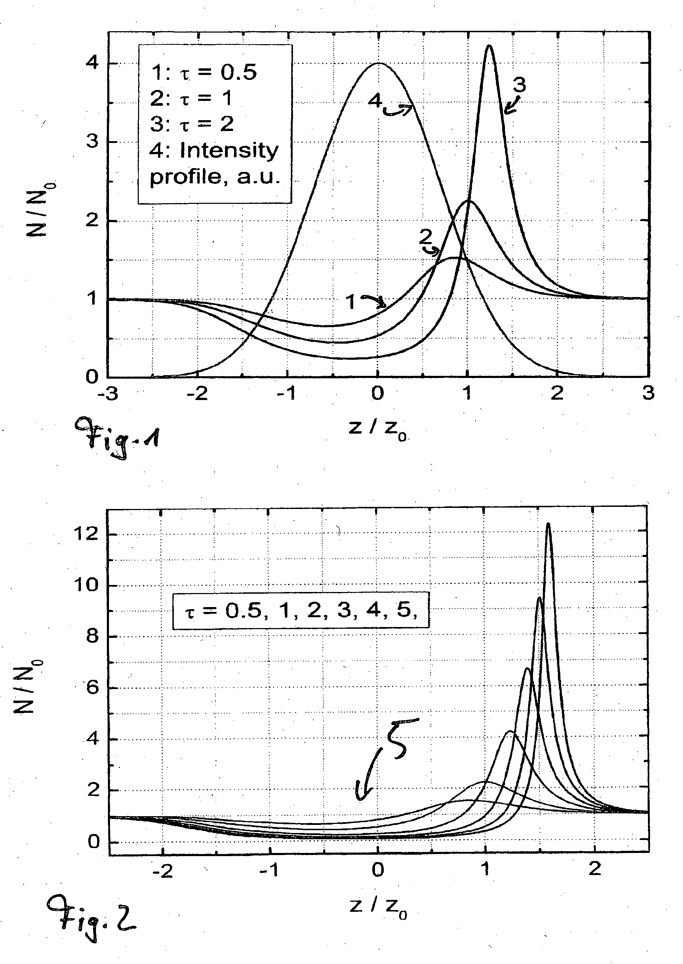

In Figur 1 zeigen die Linien 1, 2 und 3 die normierten Profile N(z/z₀)/N₀ für drei verschiedene Werte der normierten Zeit τ = 0,5, 1 und 2. Es ist zu erkennen, dass die Konzentrationsverteilung nicht symmetrisch in Bezug auf das Zentrum des Lichtstrahls ist, dessen Profil mit 4 bezeichnet ist. Die Tendenz des Verlaufs N(z/z₀)/N₀ mit wachsender Zeit t / t₀ ist deutlich ersichtlich. Die Beleuchtung verteilt Elektronen durch die zentrale Region zum rechten Rand der beleuchteten Region und erzeugt dort ein betontes Konzentrationsmaximum. Je länger die Zeit t ist, desto schärfer ist dieses Maximum.

In Figur 2 sind die lichtinduzierten Profile für jeweils größer werdende normierte Bestrahlungszeiten τ dargestellt. Es ist erkennbar, dass das Maximum mit ansteigendem τ immer spitzer wird und weiter zur rechten Seite wandert. Im Zentrum des Kristalls ist die Konzentration hingegen stetig sinkend.

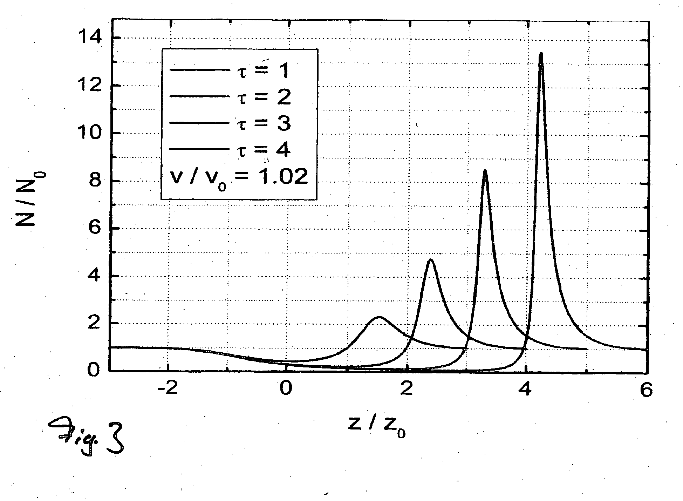

Figur 3 zeigt lichtinduzierte Konzentrationsprofile für vier Behandlungszeiten, wobei die Profile mit einem gaußförmigen Lichtstrahl erzeugt sind, der nach rechts etwa mit der optimalen Geschwindigkeit v₀ = z₀ / t₀ bewegt wurde. Der Stahl wirkt ähnlich wie eine Planierraupe, die die umverteilbaren Ladungen zur rechten Seite hin transportiert. Dahinter verbleiben die anregbaren Ladungsträger nur in sehr geringer Konzentration. Auf der anderen Seite steigt die Konzentration zu einem Maximum an. Die Spitze eines jeden Konzentrationsmaximums steigt mit der normierten Zeit τ an. Weit entfernt vom Strahl ist die Konzentration nicht beeinflusst.

## Patentansprüche

1. Verfahren zur Reinigung eines nicht dotierten Kristalls, insbesondere eines Lithiumniobat- oder Lithiumtantalat-Kristalls, für den Einsatz in einem optischen Bauteil, wobei im Kristall Fremdatome, insbesondere Fe²⁺-Ionen oder Kristallfehlstellen, vorhanden sind, die eine spezifische Absorption von eingestrahltem Licht bewirken,
wobei
der Kristall in einem ersten Schritt auf eine Temperatur erwärmt wird, bei der Ionen im Kristall beweglich sind und zu einer Leitfähigkeit führen, dass ein Teil des Kristalls in einem nachfolgenden Reinigungsschritt mit einem elektromagnetischen Reinigungsstrahl innerhalb einer für den späteren Durchtritt von Lichtstrahlen nutzbaren Zone insofern desensibilisiert wird, als die gereinigte nutzbare Zone für den späteren Einsatz erhalten bleibt, und mit einer Frequenz im oder nahe am sichtbaren Frequenzbereich beleuchtet wird,
wobei mit dem Reinigungsstrahl Ladungen optisch angeregt werden und im Kristall wandern und wobei die Ladungen durch Wanderung von Ionen kompensiert werden und dadurch nach der Reinigung fixiert sind,
und dass der Kristall auf die zukünftige Betriebstemperatur, insbesondere auf Raumtemperatur, abgekühlt wird, wobei der zuvor mit dem Reinigungsstrahl beleuchtete Bereich die für den späteren Einsatz gereinigte und damit verbessert nutzbare Zone bildet, **dadurch gekennzeichnet, dass** der Teil des Kristalls mit dem Reinigungsstrahl eines Querschnittes makroskopischer Abmessung, die im Mikrometerbereich bis Millimeterbereich liegt, beleuchtet wird.

2. Verfahren nach Anspruch 1,
**dadurch gekennzeichnet,**
**dass** der Reinigungsstrahl ein Intensitätsprofil aufweist und wäherend der Beleuchtung nicht beleuchtete oder schwach beleuchtete Zonen innerhalb des Kristalls verbleiben, wobei die Ladungen vom helleren in einen dunkleren Bereich wandern und dort von den Ionen kompensiert werden.

3. Verfahren nach Anspruch 1 oder 2,
**dadurch gekennzeichnet,**
**dass** der Kristall im ersten Schritt auf eine Temperatur, insbesondere zwischen etwa 150 und 220 °C für Lithiumniobat und Lithiumtantalat, erwärmt wird, bei der Elektronen von Defektstellen noch nicht in signifikantem Maß thermisch angeregt werden.

4. Verfahren nach einem der vorherigen Ansprüche,
**dadurch gekennzeichnet,**
**dass** der Kristall im ersten Schritt auf eine Temperatur erwärmt wird, bei der die Maxwellzeit der ionischen Leitfähigkeit zumindest nahezu der Maxwellzeit der elektronischen Leitfähigkeit entspricht.

5. Verfahren nach Anspruch 1,
**dadurch gekennzeichnet,**
**dass** als Reinigungsstrahl ein Laserstrahl eingesetzt wird.

6. Verfahren nach Anspruch 5,
**dadurch gekennzeichnet,**
**dass** der Laserstrahl eine Wellenlänge aufweist, die zumindest nahezu der des später einzusetzenden Lichts oder der des später durch den Kristall mittels eines nichtlinear-optischen Effekts erzeugten Lichts entspricht.

7. Verfahren nach einem der vorherigen Ansprüche,
**dadurch gekennzeichnet,**
**dass** der Reinigungsstrahl ein Intensitätsprofil mit abfallenden Flanken, insbesondere ein gaußförmiges Profil, hat.

8. Verfahren nach einem der vorherigen Ansprüche,
**dadurch gekennzeichnet,**
**dass** der Reinigungsstrahl, insbesondere mehrfach, in einer Richtung über den Kristall verfahren wird.

9. Verfahren nach Anspruch 8,
**dadurch gekennzeichnet,**
**dass** der Reinigungsstrahl entlang oder entgegen der Richtung des volumenphotovoltaischen Stroms verfahren wird.

10. Verfahren nach Anspruch 1,
**dadurch gekennzeichnet,**
**dass** die umverteilten Ladungen durch Kompensation mit ionischen Ladungen, insbesondere H⁺ und Li⁺, fixiert werden.

11. Verfahren nach einem der vorherigen Ansprüche ,
**dadurch gekennzeichnet,**
**dass** der Kristall von den nicht gereinigten Bereichen, insbesondere durch Abschneiden, befreit wird.

12. Verfahren nach Anspruch 1,
**dadurch gekennzeichnet,**
**dass** während der Beleuchtung ein äußeres elektrisches Feld an den Kristall angelegt wird, um die Umverteilung der mit Licht angeregten Ladungen zu verstärken.

13. Verfahren nach einem der vorherigen Ansprüche,
**dadurch gekennzeichnet,**
**dass** vor der Behandlung für die Leitung geeignete Ionen beispielsweise in feuchter Atmosphäre in den Kristall eingebracht werden.

## Claims

1. A method for purifying an undoped crystal, in particular a lithium niobate or lithium tantalite crystal, for use in an optical component, wherein foreign atoms, in particular Fe²⁺ ions or crystal effects, are present in the crystal and cause a specific absorption of irradiated light,
wherein the crystal is heated in a first step to a temperature at which the ions in the crystal are movable and lead to a conductivity,
wherein part of the crystal is desensitised in a subsequent purification step with an electromagnetic purification beam within a zone usable for the subsequent passage of light beams insofar as the purified usable zone is retained for subsequent use and is illuminated at a frequency in or close to the visible frequency range,
wherein charges are exited optically with the purification beam and migrate in the crystal, and wherein the charges are compensated for by migration of ions and are thus fixed following the purification,
and wherein the crystal is cooled to the future operating temperature, in particular to room temperature, wherein the regions previously illuminated with the purification beam forms the usable zone purified for the subsequent use and thus improved, **characterised in that** the part of the crystal is illuminated with the purification beam of a cross section of macroscopic dimension in the micrometre range to millimetre range.

2. The method according to Claim 1,
**characterised in that**
the purification jet has an intensity profile and unilluminated or weakly illuminated zones remain within the crystal during the illumination, wherein the charges migrate from lighter into darker region, where they are compensated for by the ions.

3. The method according to Claim 1 or 2,
**characterised in that**
the crystal is heated in the first step to a temperature, in particular between approximately 150 and 220 °C for lithium niobate and lithium tantalite, at which temperature electrons of defects are not yet thermally excited to a significant extent.

4. The method according to one of the preceding claims, **characterised in that**
the crystal is heated in the first step to a temperature at which the Maxwell time of the ionic conductivity corresponds at least approximately to the Maxwell time of the electronic conductivity.

5. The method according to Claim 1,
**characterised in that**
a laser beam is used as purification beam.

6. The method according to Claim 5,
**characterised in that**
the laser beam has a wavelength that corresponds at least approximately to the light to be used subsequently or to the light generated subsequently by the crystal by means of a non-linear optical effect.

7. The method according to one of the preceding claims,
**characterised in that**
the purification beam has an intensity profile with falling flanks, in particular has a Gaussian profile.

8. The method according to one of the preceding claims,
**characterised in that**
the purification beam is moved in a direction over the crystal, in particular a number of times.

9. The method according to Claim 8,
**characterised in that**
the purification beam is moved along or against the direction of the volume photovoltaic current.

10. The method according to Claim 1,
**characterised in that**
the redistributed charges are fixed by compensation with ionic charges, in particular H⁺ and Li⁺.

11. The method according to one of the preceding claims,
**characterised in that**
the crystal is freed from the non-purified regions, in particular by cutting.

12. The method according to Claim 1,
**characterised in that**
an outer electric field is applied to the crystal during the illumination in order to intensify the redistribution of the charges excited by light.

13. The method according to one of the preceding claims,
**characterised in that**
prior to the treatment ions suitable for the line are introduced into the crystal, for example in moist atmosphere.

## Revendications

1. Procédé de purification d'un cristal non-dopé, s'agissant notamment d'un cristal de niobate de lithium ou de tantalate de lithium, lequel est destiné à être mis en oeuvre dans un composant optique, ledit cristal comportant des atomes étrangers, s'agissant notamment d'ions Fe²⁺ ou de défauts cristallins, dont la présence se traduit par une absorption spécifique d'une lumière incidente,
ledit cristal étant dans une première étape chauffé à une température à laquelle les ions présents dans ledit cristal deviennent mobiles et provoquent ainsi une conductivité telle que, lors d'une étape de purification ultérieure, une partie dudit cristal située au sein d'une zone pouvant être utile à faire passer ultérieurement des rayons lumineux est désensibilisée au moyen d'un faisceau électromagnétique de purification, faisant en sorte que suite à sa purification la zone utile puisse être conservée pour son utilisation ultérieure et soit exposée à une lumière d'une fréquence correspondant au domaine de fréquences visible ou s'en approchant,
ledit faisceau de purification provoquant une excitation de charges par effet optique ainsi que leur migration au sein du cristal, lesdites charges étant compensées par la migration d'ions ce qui permet d'immobiliser lesdites charges après la purification,
et ledit cristal étant refroidi à sa future température d'exploitation, notamment à la température ambiante, la zone précédemment exposée à la lumière du faisceau de purification formant alors une zone qui a été purifiée en vue de sa mise en oeuvre ultérieure et qui présente ainsi une utilité améliorée, **caractérisé en ce que** ladite partie du cristal est exposée à la lumière d'un faisceau de purification ayant une section transversale de dimension macroscopique située dans le domaine micrométrique voire millimétrique.

2. Procédé selon la revendication 1,
**caractérisé en ce que**
le faisceau de purification présente un profil d'intensité et que, pendant l'exposition à la lumière, il persiste au sein dudit cristal des zones non-exposées ou faiblement exposées à la lumière, les charges effectuant une migration depuis la zone à exposition relativement forte vers une zone à exposition relativement faible pour y être compensées par des ions.

3. Procédé selon les revendications 1 ou 2, **caractérisé en ce que**,
dans la première étape, ledit cristal est chauffé à une température, située notamment entre environ 150 et 220 °C dans le cas du niobate de lithium et du tantalate de lithium, à laquelle les électrons des défauts cristallins ne subissent pas encore d'excitation thermique significative.

4. Procédé selon l'une des revendications précédentes,
**caractérisé en ce que**,
dans la première étape, le cristal est chauffé à une température à laquelle le temps de Maxwell de la conductivité ionique correspond au moins approximativement au temps de Maxwell de la conductivité électronique.

5. Procédé selon la revendication 1,
**caractérisé en ce que**
l'on met oeuvre un faisceau laser en tant que faisceau de purification.

6. Procédé selon la revendication 5,
**caractérisé en ce que**
ledit faisceau laser présente une longueur d'onde correspondant au moins approximativement à celle de la lumière à mettre en oeuvre ultérieurement ou à celle de la lumière ultérieurement produite par ledit cristal au moyen d'un effet de nature non-linéaire optique.

7. Procédé selon l'une des revendications précédentes,
**caractérisé en ce que**
le faisceau de purification présente un profil d'intensité pourvu de flancs inclinés vers le bas, s'agissant notamment d'un profil gaussien.

8. Procédé selon l'une des revendications précédentes,
**caractérisé en ce que**
le faisceau de purification est déplacé à travers ledit cristal dans un sens, notamment plusieurs fois.

9. Procédé selon la revendication 8,
**caractérisé en ce que**
le faisceau de purification est déplacé dans le sens de circulation du courant provoqué par l'effet photovoltaïque anomal, ou bien dans le sens opposé.

10. Procédé selon la revendication 1,
**caractérisé en ce que**
l'immobilisation des charges redistribuées est réalisée en les compensant par des charges ioniques, notamment par H⁺ et Li⁺.

11. Procédé selon l'une des revendications précédentes,
**caractérisé en ce que**
les zones n'ayant pas subi de purification sont écartées dudit cristal, notamment en les coupant.

12. Procédé selon la revendication 1,
**caractérisé en ce que**,
pendant l'exposition à la lumière, on soumet ledit cristal à un champ électrique extérieur, pour ainsi renforcer la redistribution des charges excitées sous l'effet de la lumière.

13. Procédé selon l'une des revendications précédentes,
**caractérisé en ce que**,
préalablement au traitement, on introduit dans le cristal des ions appropriés à la conduction, ladite introduction étant par exemple réalisée sous atmosphère humide.
